(19) Europäisches Patentamt European Patent Office Office européen des brevets

(11) **EP 4 439 026 B1**

(12) **EUROPEAN PATENT SPECIFICATION**

(45) Date of publication and mention
of the grant of the patent:
**02.04.2025 Bulletin 2025/14**

(21) Application number: **23305442.8**

(22) Date of filing: **29.03.2023**

(51) International Patent Classification (IPC):
$G01K\ 7/01^{(2006.01)}$ $G01K\ 15/00^{(2006.01)}$

(52) Cooperative Patent Classification (CPC):
**G01K 7/01; G01K 15/005;** G01K 2217/00

(54) **ON-LINE DYNAMIC RESOLUTION OF TIME-BASED TEMPERATURE ESTIMATION**

DYNAMISCHE ONLINE-AUFLÖSUNG ZEITBASIERTER TEMPERATURSCHÄTZUNG

RÉSOLUTION DYNAMIQUE EN LIGNE D'ESTIMATION DE TEMPÉRATURE BASÉE SUR LE TEMPS

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**02.10.2024 Bulletin 2024/40**

(73) Proprietors:
• **Mitsubishi Electric R&D Centre Europe B.V.**
**1119 NS Schiphol Rijk Amsterdam (NL)**
Designated Contracting States:
**FR**
• **MITSUBISHI ELECTRIC CORPORATION**
**Chiyoda-ku**
**Tokyo 100-8310 (JP)**
Designated Contracting States:
**AL AT BE BG CH CY CZ DE DK EE ES FI GB GR HR HU IE IS IT LI LT LU LV MC ME MK MT NL NO PL PT RO RS SE SI SK SM TR**

(72) Inventors:
• **Quemener, Vincent**
**35708 RENNES CEDEX 7 (FR)**
• **DEGRENNE, Nicolas**
**35708 RENNES CEDEX 7 (FR)**

(74) Representative: **Plasseraud IP**
**104 Rue de Richelieu**
**CS92104**
**75080 Paris Cedex 02 (FR)**

(56) References cited:
**EP-A1- 3 855 145**

• **JULIO BRANDELERO ET AL: "On-line Virtual Junction Temperature Measurement via DC Gate Current Injection", CIPS 2018 - 10TH INTERNATIONAL CONFERENCE ON INTEGRATED POWER ELECTRONICS SYSTEMS, 20-22 MARCH 2018, STUTTGART, GERMANY, 5 July 2018 (2018-07-05), Berlin - Offenbach, XP055604490, ISBN: 978-3-8007-4540-1, Retrieved from the Internet <URL:https://ieeexplore.ieee.org/ielx7/8402817/ 8402818/08403170.pdf?tp=& arnumber=8403170&isnumber=8402818& ref=aHR0cHM6Ly9pZWVleHBsb3JlLmllZ WUub3JnL2RvY3VtZW50Lzg0MDMxNzA=> [retrieved on 20190710]**

## Description

### Technical Field

This disclosure pertains to the field of power semiconductor monitoring, and related calibration method, that are applicable during the operational life of such components.

### Background Art

It is known to monitor temperature in power semiconductor devices/modules, like multichip power modules, for protection, condition and health monitoring because the temperature is one of the main failure origins. The datasheet of power semiconductor provides the maximum junction temperature where it can operate without thermal runaway and consequent catastrophic failure. Therefore, monitoring the junction temperature, or at least the maximum junction temperature measurement, is a great interest to ensure the safe operation of the device.

Generally, the free surface of a die is very small. To fix a sensor on it is difficult, and even impossible in some cases. The number of external connections is high, and the acquisition system is complex. To do it in laboratory conditions is very difficult. In real, industrial and operational situations, to use individual PN junction sensors is not realistic. In addition, sensors have to be integrated inside the power module packaging which means that the presence of sensors have to be initially planned during the conception of the module and to retrofit to the existing power modules is impossible.

Many Temperature Sensitive Electrical Parameters (TSEP) based methods and in-chip sensors for on-line junction temperature estimation on power semiconductor are known. This allows to have direct access to the junction temperature without the need of an external sensor. Typically, the measurement of the TSEP of a transistor is performed with an Analog-to-Digital Converter (ADC). The use of an ADC can be a limitation for low-cost systems since the resolution and sampling speed of the ADC directly relate to the quality of the temperature estimation. A TSEP of a transistor can be a time. More specifically, a TSEP of a transistor can be measured as a time duration relative to a detection threshold. A measurement of time may be a problem because of low temperature to time sensitivity. A simplest way is to monitor the passing of the temperature above a critical, safety-related, temperature value. This can be made with an analogue comparator comparing the TSEP value to a threshold value. Such a technic is described in EP 3 855 145 A1. In this way, an ADC is not required but this limits the measurement to one specific temperature value. The specific temperature value is adjusted to correspond to the over-temperature of a specific power transistor. However, such a method presents the following limitations:

- Only one temperature is monitored. The predetermined temperature threshold is selected, generally according to a datasheet provided by the manufacturer.
- Monitoring multiple temperature values is possible but has a direct impact on the circuit and calibration complexity. Multiple temperatures can indeed be monitored by duplicating the monitoring circuit. The number of emulator components is thus multiplied, as well as the calibration effort.
- The Over-Temperature-Detection (OTD) circuit hardware needs to be specific for each monitored device. The TSEP characteristics being unique for each device, a calibration must be done for each OTD circuit. This limits the functionality of the OTD for one specific transistor.
- The OTD circuit is not modifiable, it cannot be adjusted during operation. A deviation of the TSEP during the mission profile of the device cannot be excluded which may alter the operation of the OTD, for example by modifying the measured temperature value.
- When the TSEP of a power transistor is the time, the time-to-temperature sensitivity is low. This will either lead to low precision/accuracy and/or require costly signal conditioning circuits.

### Summary

This disclosure improves the situation.

It is proposed a measurement method for estimating junction temperatures of a power semi-conductor module according to claim 1.

In another aspect, it is proposed a computer software according to claim 4 comprising instructions to cause a power semi-conductor module to implement the method as defined here when the software is executed by a processor. In another aspect, it is proposed a computer-readable non-transient recording medium on which a software is registered to implement the method as defined here when the software is executed by a processor.

The following features, can be optionally implemented, separately or in combination one with the others:
The resistance of said emulator circuit is tunable. The value of said resistance is set in such a way that the temperature estimation range position is selected. The capacitor of said emulator circuit is tunable. The value of said capacitor is set in such a way that the temperature estimation range amplitude is selected.

The method further comprises iteratively modifying the value of said resistance while the time duration t is fixed to a value close to zero and until the generated comparison signal corresponds to a situation wherein said voltage signal of said power transistor is equal to said voltage signal of said emulator circuit.

The module further comprises:

- a controller arranged to tune said resistance and/or said capacitor.

**Brief Description of Drawings**

Other features, details and advantages will be shown in the following detailed description and on the figures, on which:

**Fig. 1**

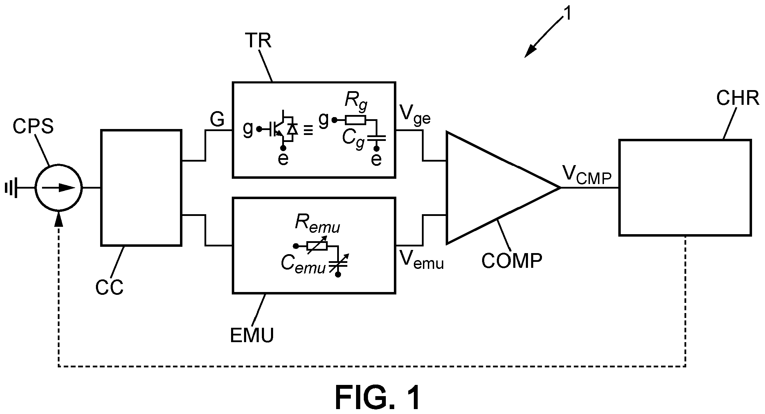

[Fig. 1] is a schematic view of a module according to some embodiments.

**Fig. 2**

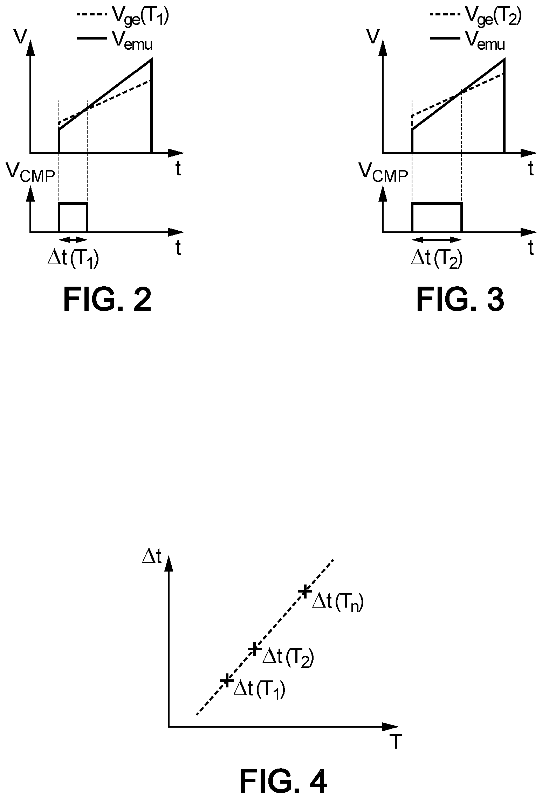

[Fig. 2] is a graphical representation of the measured output voltages during a current pulse and a corresponding comparison signal.

**Fig. 3**
[Fig. 3] is a graphical representation of the measured output voltages during a current pulse and a corresponding comparison signal.

**Fig. 4**
[Fig. 4] is a graphical representation of the linear relationship of the signal duration as a function of the temperature deduced from comparisons like in [Fig. 2] and [Fig. 3].

**Fig. 5**

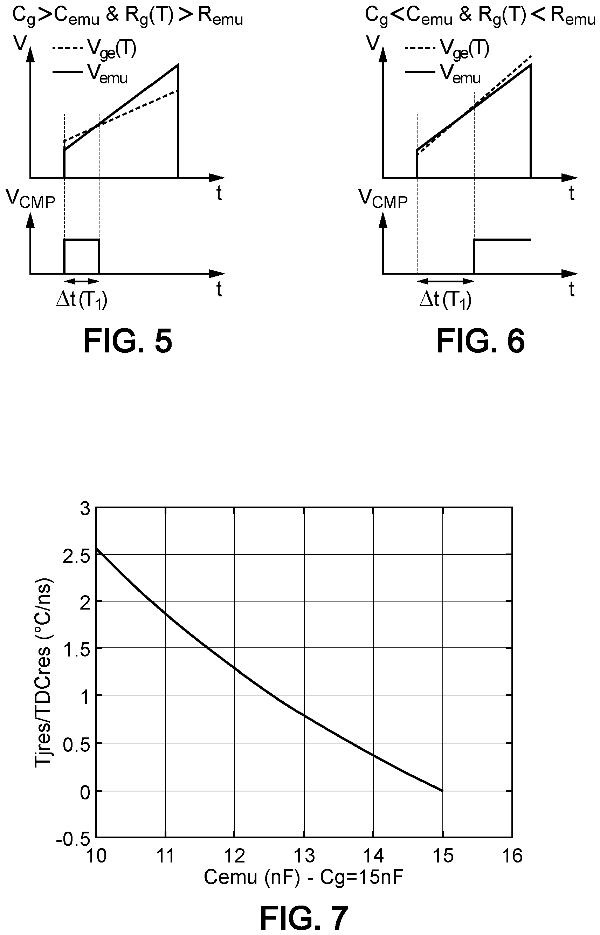

[Fig. 5] is similar to [Fig. 2] or [Fig. 3] in a situation where $C_g > C_{emu}$.

**Fig. 6**
[Fig. 6] is similar to [Fig. 2] or [Fig. 3] in a situation where $C_g < C_{emu}$.

**Fig. 7**
[Fig. 7] is a graphic view of the temperature-to-time resolution as a function of the emulator capacitance.

**Fig. 8**

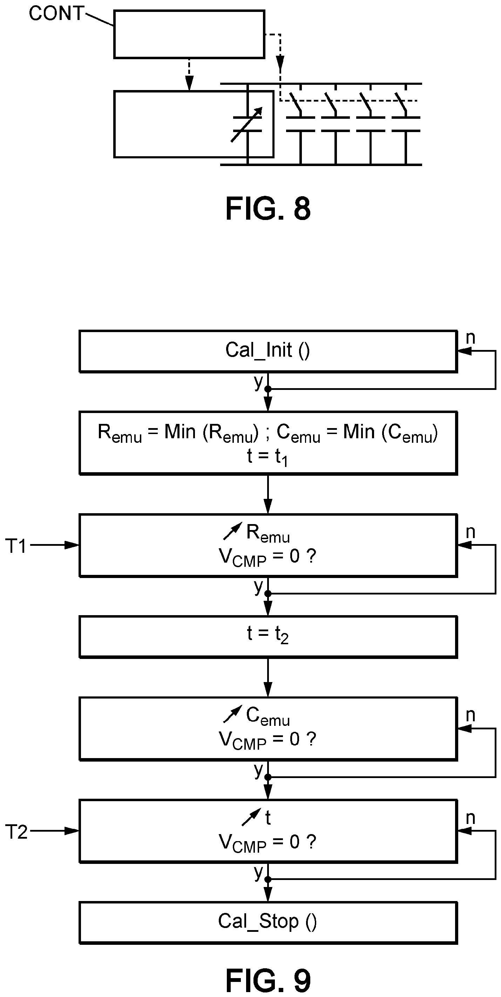

[Fig. 8] is a schematic representation of a controller arrangement to tune an emulator circuit.

**Fig. 9**
[Fig. 9] is a flowchart of an algorithm that can be executed during an embodiment.

**Fig. 10**

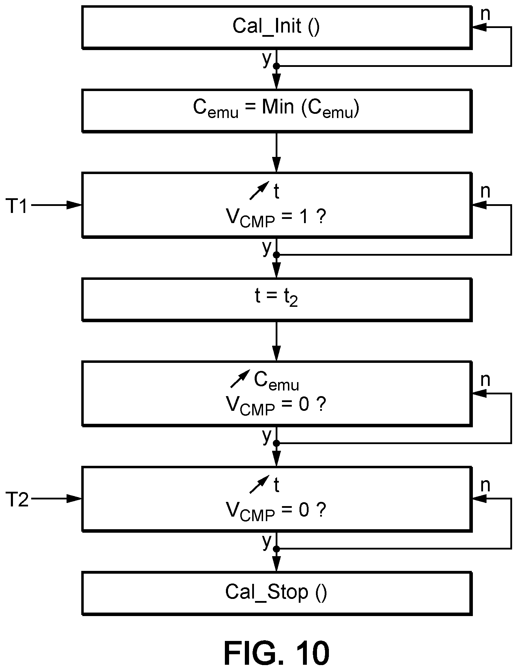

[Fig. 10] is a flowchart of an algorithm that can be executed during an embodiment.

**Fig. 11**

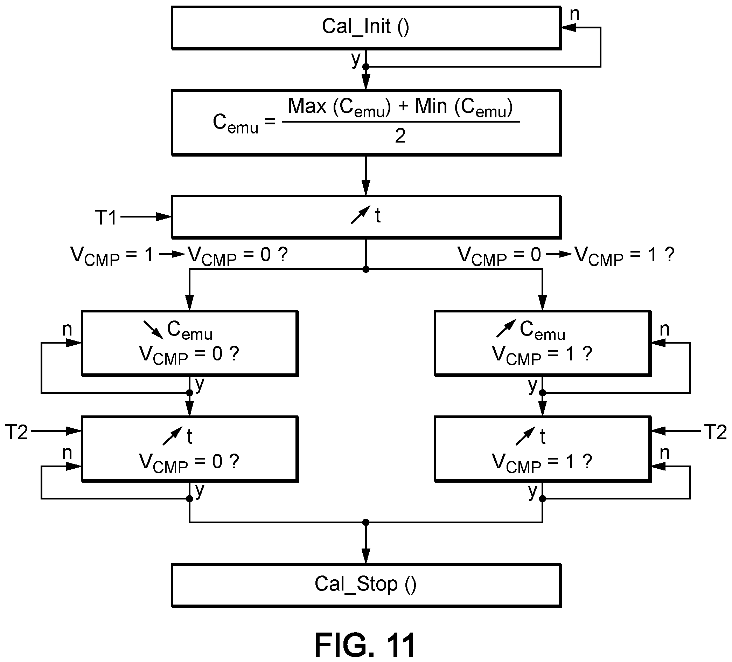

[Fig. 11] is a flowchart of an algorithm that can be executed during an embodiment.

**Fig. 12**

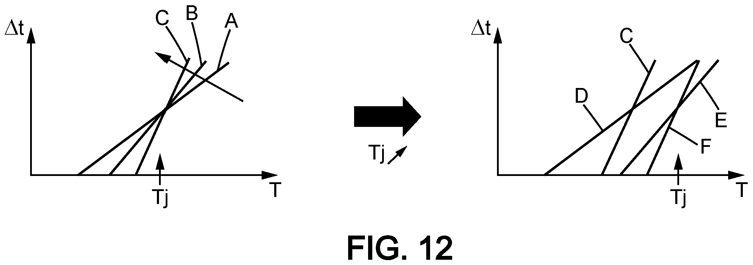

[Fig. 12] is a graphical representation of a dynamic adaptation of an emulator circuit.

**Fig. 13**

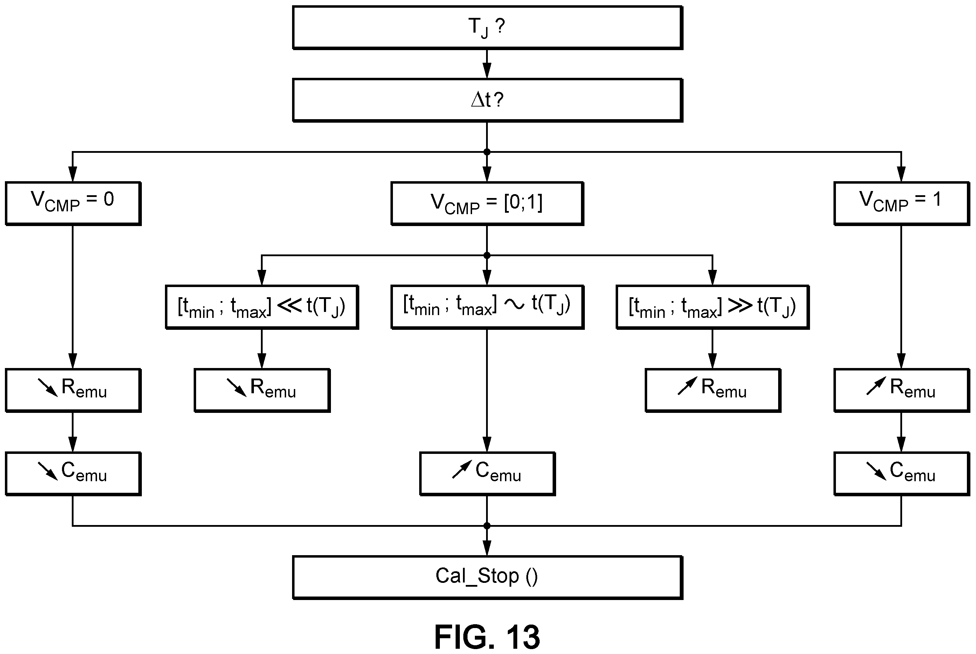

[Fig. 13] is a flowchart of an algorithm that can be executed during an embodiment.

**Fig. 14**

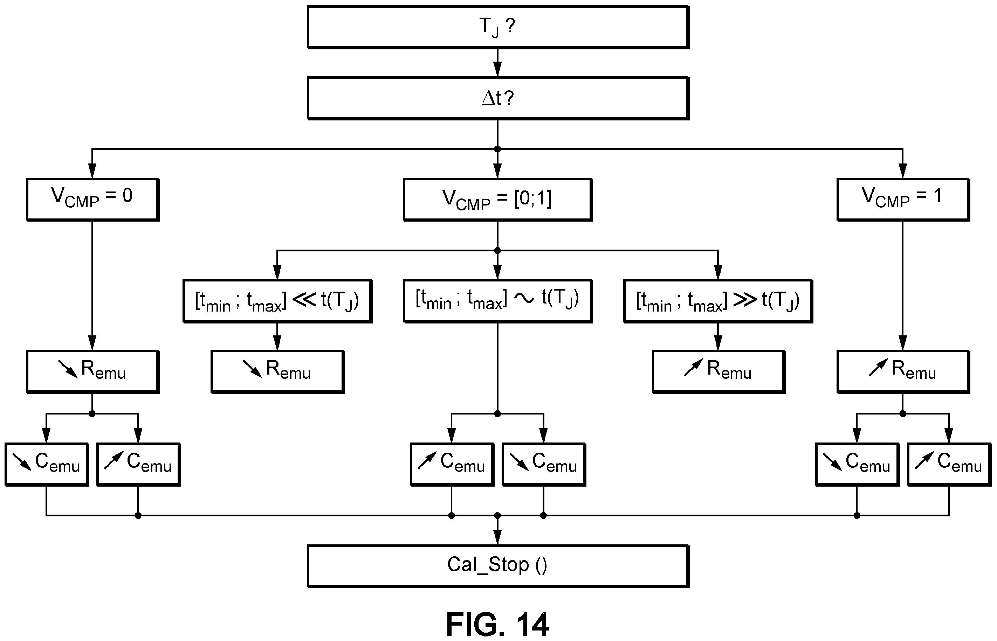

[Fig. 14] is a flowchart of an algorithm that can be executed during an embodiment.

**Fig. 15**

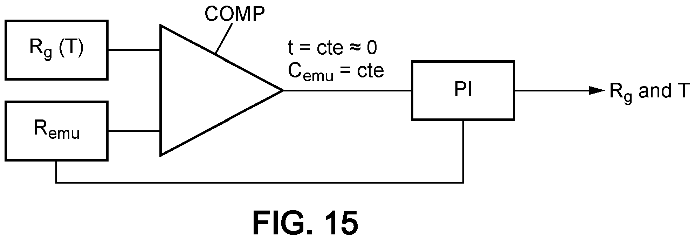

[Fig. 15] is a schematic representation of an embodiment of a dynamic adaptation of an emulator circuit.

**Description of Embodiments**

Here, the word *"power"* is used in its general meaning of the technical field of energy conversion (power electronics). In addition, the solutions described hereinafter are made to be used during operational lifetime of the power semi-conductor modules under "normal" conditions, which means that it is not limited to the context of a laboratory or a test bench under ideal and controlled conditions like post-production quality control phases.

It is now referred to [Fig. 1] showing a module power semi-conductor module 1. The power semi-conductor module 1 comprises:

- at least one power transistor TR;
- a current pulse source CPS that is provided through a control electrode G of said power transistor TR;
- a current copier CC arranged to duplicate the current provided by the current pulse source;
- an emulator circuit EMU comprising a resistance $R_{emu}$ in series with a capacitor $C_{emu}$;
- a comparator COMP arranged to compare a voltage signal $V_{ge}$ of said power transistor TR and a voltage signal $V_{emu}$ of said emulator circuit EMU, here in such a way to generate a comparison signal $V_{CMP}$.

On [Fig. 1], the module 1 further comprises a time detector CHR. The time detector CHR is arranged to measure a time duration of the comparison signal $V_{CMP}$. Structurally, the time detector CHR can be a specific module by itself or can be a sub-module functionally integrated to the Comparator COMP.

Examples of measurement method for estimating junction temperatures of a power semi-conductor module like the one shown on [Fig. 1] will now be described.

In a first operation, a pulse current is duplicated in two identical pulse currents. In the example of [Fig. 1], a pulse current from the current pulse source CPS is duplicated by the current copier CC, for example a "current mirror circuit". The aim is to inject the same current pulse, simultaneously, in the transistor TR and in the emulator circuit EMU.

In a second operation, the first and second duplicated pulses currents are injected simultaneously respectively in a control electrode of the power transistor TR and in the emulator circuit EMU. In the example of [Fig. 1], the control electrode is the gate G of the transistor TR. Doing this, the internal gate resistance of the transistor (present within the structure of the transistor) is used as a TSEP.

In a third operation, the resulting voltages $V_{ge}$ and $V_{emu}$ are compared. In the example of [Fig. 1], the comparison is made by means of the comparator COMP between the gate-emitter voltage $V_{ge}$ of the transistor TR and the output voltage $V_{emu}$ of the emulator circuit EMU.

The resulting voltages $V_{ge}$ and $V_{emu}$ can be described respectively by the following equations [Math. 1] and [Math. 2].

[Math. 1]

$$V_{ge} = R_g(T_j) \cdot I + \frac{t}{C_g} \cdot I$$

[Math. 2]

$$V_{emu} = R_{emu} \cdot I + \frac{t}{C_{emu}} \cdot I$$

where I is the current, t is the time and $R_g(T_j)$ is the gate resistor.

The gate resistor $R_g$ depends linearly on the temperature and can be described by the following equation [Math. 3].

[Math. 3]

$$R_g(T_j) = (\delta R_g \cdot T_j + 1)R_{g0}$$

In the example, the comparison is binary: the output signal $V_{CMP}$ is equal to "1" when the transistor voltage is superior or equal to the emulator circuit voltage ($V_{ge} \geq V_{emu}$), and "0" in the other cases ($V_{ge} < V_{emu}$). Thus, the time duration of the situation wherein the transistor voltage is superior or equal to the emulator circuit voltage ($V_{CMP} = 1$) can be measured using equations [Math. 1] and [Math. 2], according to the following equation [Math. 4].

[Math. 4]

$$\Delta t = \left(R_g\left(T_j\right) - R_{emu}\right) \cdot \frac{C_g \cdot C_{emu}}{C_g - C_{emu}}$$

Here, the difference is analyzed with a binary value ("1" or "0") because the value of the difference is not relevant by itself. Only the duration of the sign of the difference is. In various embodiments, the comparison of the two voltages can be made differently and can be analogic for example.

The relation between time and temperature is independent of the value of the current injection. Thus, the method is robust to the imperfections of the current pulse source CPS and allows a good precision and a low-drift even if a low-cost current injection circuit is used. The temperature can be measured without additional ADC, considerably reducing the cost of the junction temperature $T_j$ measurement. Instead, a Time-to-Digital Converter (TDC) can be used, or even the time to digital conversion can be implemented in an FPGA, eventually in the same FPGA that generates control signals of a switch and other functions of the module 1.

The comparison of $V_{ge}$ and $V_{emu}$ is graphically represented on [Fig. 2], [Fig. 3] and [Fig. 4]. [Fig. 2] corresponds to the implementation under a first temperature $T_1$ while [Fig. 3] corresponds to the implementation under a second temperature $T_2$.

In a fourth operation, the measured duration $\Delta t$ is converted into a junction temperature T thanks to the linear relationship of the duration $\Delta t$ as a function of the temperature T. As it is represented on [Fig. 4], the said relationship can be deduced from plurality of measurement at various temperatures $T_n$.

A Time-to-Digital Converter (TDC) can be used to implement the conversion, including TDC known by themselves. Some TDC offer resolutions better than 1ns. For example, the component having the commercial reference "TDC7401ZAXRé has a resolution of 55ps. The temperature resolution can be expressed as a function of the TDC resolution with the following equation [Math. 5].

[Math. 5]

$$\frac{Tj_{res}}{TDC_{res}} = \frac{\left(C_g - C_{emu}\right)}{\left(C_g \cdot C_{emu}\right) \cdot \delta R_g}$$

The temperature-to-time resolution can easily be less than 1°C/ns, meaning that a TDC with a resolution of 55ps would allow to obtain a temperature resolution of less than 0.055°C. To be convinced of the great resolution that can be reached by such a method, we should compare it to a current injection known in the art of 100mA and a resistance to temperature resolution of 0.013Ω/°C: in such a case, the temperature resolution is in the order of 0.5°C with a known 14bit ADC and a $\pm$5V rail.

The temperature resolution, and subsequent accuracy and precision can be much lower than state of the art methods.

In the proposed example, the output signal value of the comparator COMP can be either 0 or 1. Depending on the value of $R_{emu}$ and $C_{emu}$, two cases can be considered. The two cases are shown respectively on [Fig. 5] and [Fig. 6]. In a first case ([Fig. 5]), $C_g$ and $R_g$ are higher than $C_{emu}$ and $R_{emu}$ respectively. The output signal $V_{CMP}$ of the comparator COMP is equal to "1" and the length (duration) of the signal will be proportional to the temperature $T_j$. In a second case ([Fig. 6]), $C_g$ and $R_g$ are lower than $C_{emu}$ and $R_{emu}$ respectively. The output signal $V_{CMP}$ of the comparator COMP is equal to "0" and the length (duration) of the signal will be proportional to the temperature $T_j$.

In the examples, the emulator circuit EMU is tunable: the value of the resistance $R_{emu}$ can be set and the value of the capacitor $C_{emu}$ can be set (independently one with respect to the other). In various embodiment, only the resistance is tunable or only the capacitor is tunable. In other embodiments, the emulator circuit EMU is not tunable.

When the capacitor value $C_{emu}$ is settable, it is thus possible to estimate the temperature only by setting $C_{emu}$ independently of the value of $R_{emu}$. When $R_{emu} < R_g$ (see [Fig. 5]) and $R_{emu} > R_g$ (see [Fig. 6]), $C_{emu} < C_g$ and $C_{emu} > C_g$, respectively. Thus, for example, a calibration process only of $C_{emu}$ at the end of the manufacturing of the module 1 can be performed, after the $T_j$ estimation circuit is connected to the transistor TR.

For a given value of $R_{emu}$:

- if no signal ("0") is detected at the output of the comparator COMP, $C_{emu}$ must be increased;
- if only a positive signal ("1") is detected at the output of the comparator COMP, $C_{emu}$ must be decreased.

When the capacitor value $C_{emu}$ is settable, it is thus possible to increase the temperature-to-time resolution by setting $C_{emu}$ close to $C_g$. According to the equation [Math. 5], the closer the $C_{emu}$ is and the higher the temperature-to-time resolution is. This is shown on [Fig. 7]: the temperature-to-time resolution as a function of $C_{emu}$-$C_g$ is plotted. On can see that the resolution increases for $C_{emu}$ closer to $C_g$.

Decreasing the capacitance $C_{emu}$ (during the operational life of the module 1) can be made by use of a laser trimmable chip capacitor built up as multilayer plate capacitors. Vaporizing the top layer with a laser decreases the capacitance by reducing the area of the top electrode. Depending on the industrial context, the resistor trimming process can be replaced by a capacitor trimming process when it is more convenient.

**Calibration**

In some embodiments with an emulator circuit EMU having a tunable resistance $R_{emu}$ and a tunable capacitor $C_{emu}$, further operations of calibration can be implemented. In such a case, the module 1 can further comprise a controller CONT.

As an example, tunable capacitor and resistor can be digitally potentiometers controlled by the controller CONT, such as an FPGA. Only as an example, the component having the commercial reference "NCD2400MTR" can be used and give a range of 200pF with 512 discrete 355fF steps. If this range is not sufficient to cover full range of different device capacitance, the range can be increase by adding several bigger capacitances in parallel with one "NCD2400MTR" and controlled by the FPGA, as shown on [Fig. 8].

As a second example, a n-bit R-2R resistor ladder network controlled by an FPGA can be used. This allows to get 2n resistors steps directly tunable by the FPGA. As a third example, digital potentiometer such as the component having the commercial reference "AD5258" with 64 resistor steps can be used.

A person skilled in the art would choose an emulator circuit EMU, including the controller CONT, adapted in function of the transistors to drive and the operational conditions, to adapt the range of capacitance. By using tunable capacitor and resistor, the TSEP of the transistor can be automatically calibrated using different algorithms. This allows to change (only) the transistor and keeping the temperature measurement operational. In addition, during the operational lifetime of the transistor (not only in laboratory conditions on a test bench), calibration procedures can be made regularly to balance any TSEP parameters variation.

[Fig. 9], [Fig. 10] and [Fig. 11] are three examples of algorithms of calibration that can be used.

In the example of [Fig. 9], the transistor is exposed at two different temperatures T1 and T2. The capacitor $C_{emu}$ and the resistor $R_{emu}$ are initially set at their lower values in order to obtain different output voltages between the transistor and the emulator circuit. This situation corresponds to $V_{CMP}$ = 1 if this algorithm of calibration is combined with the comparator COMP above described. The assembly is set at one first fixed temperature T1 and the time detection is set at one time t1. The resistance $R_{emu}$ is gradually increased until obtaining the same output voltages between the transistor and the emulator circuit ($V_{CMP}$ = 0). Then, the time detection is set at another time t2 and the capacitance $C_{emu}$ is gradually increased until obtaining different output voltages between the transistor and the emulator circuit ($V_{CMP}$ = 1). Doing this, the time detection sensitivity is set. Finally, the temperature is fixed at a second temperature T2 and a time scan is performed until obtaining the same output voltages between the transistor and the emulator circuit ($V_{CMP}$ = 0).

The example of [Fig. 9] enables to reduce the calibration effort because the module 1 has to be exposed to only two different temperatures T1 and T2. A usual (cheap) FPGA is sufficient to do that.

In the example of [Fig. 10], only the value of the capacitor $C_{emu}$ is modified. The time detection is gradually increased to set the time detection corresponding to a first temperature T1. Then, the capacitor $C_{emu}$ is gradually increased to fix the resolution of the detector. Finally, the temperature is fixed at a second temperature T2 and the time detection is gradually increased until obtaining different output voltages between the transistor and the emulator circuit ($V_{CMP}$ = 1).

The example of [Fig. 10] enables to use a fixed (not tunable) resistance $R_{emu}$.

The example of [Fig. 11] is adapted to the two situations previously described when the resistance $R_g$ of the transistor is superior to the resistance $R_{emu}$ of the emulator circuit ($R_g > R_{emu}$ ; see [Fig. 5]), and when the resistance $R_g$ of the transistor is inferior to the resistance $R_{emu}$ of the emulator circuit ($R_g < R_{emu}$ ; see [Fig. 6]). Initially, the capacitance $C_{emu}$ is fixed at an intermediate value (for example a middle of the known range) and the temperature is fixed at one first known temperature T1. The time detection is gradually increased. If the output voltages between the transistor and the emulator circuit was different and become equal ($V_{CMP}$ changes from 1 to 0), it means that $R_g > R_{emu}$ and we are in the case of [Fig. 5]. On the contrary, if output voltages between the transistor and the emulator circuit was equal and become different ($V_{CMP}$ changes from 0 to 1), it means that $R_g < R_{emu}$ and we are in case of [Fig. 6]. Then, the capacitance $C_{emu}$ is

decreased in the first case ($R_g > R_{emu}$) and is increased in the second case ($R_g < R_{emu}$) to set the time sensitivity. Then, the temperature is fixed at a second known temperature T2 and the time detection is gradually increased until obtaining the same output voltages between the transistor and the emulator circuit (VCMP = 0) in the first case ($R_g > R_{emu}$), or until obtaining different output voltages between the transistor and the emulator circuit ($V_{CMP}$ = 1) in the second case ($R_g < R_{emu}$).

In the example of [Fig. 11] the value of the resistance $R_{emu}$ of the emulator circuit with respect to the resistance $R_g$ of the transistor is less critical, and $R_{emu}$ may be a fixed resistor value instead of a tunable value.

One way to expose a transistor to a known temperature (T1 or T2) is to consider the ambient (heat-sink) temperature when said transistor has been in off-state for several minutes. Another way to expose the transistor to a known temperature is to consider the baseplate temperature when said transistor has been in off-state for several seconds. The temperature exposure can be performed *ex-situ* (i.e. outside the module), with a heat-plate, and/or *in-situ,* by considering the temperature at two different instants.

**Dynamic resolution of Time-based $T_J$ estimation**

As it is above explained, an emulator circuit EMU having a tunable resistance $R_{emu}$ and a tunable capacitor $C_{emu}$ enables to calibrate the emulator circuit EMU in function of the transistor, for example only one time after the manufacturing/assembling process, periodically during the operational life of the module (for example during maintenance operations) or even during the "normal" operations of the modules. In the following, we will focus on solutions specifically adapted to be implemented dynamically, during the operational life of the module, to dynamically adapt the resolution of the temperature estimation when the temperature changes by mean of an embedded controller.

The range of temperature that can be estimated is related to the resistance $R_{emu}$ of the emulator circuit EMU while the amplitude (the sensitivity) of the temperature that can be deduced from the time t is related to the conductance $C_{emu}$ of the emulator circuit EMU. In other words, contrary to the prior art solutions where a definitive compromise must be made between a large amplitude and a high resolution, the solutions that we propose here enable to automatically and dynamically optimize the range and the resolution to each transistor and to each state of life (changing characteristics) of each transistor.

As an example, one target of the calibration can be to cover a range of temperatures comprised between 125°C and 200°C (i.e. for protection). Alternatively, the target is to cover a range comprised between -40°C and 200°C (i.e. for counting the temperature cycles). For a specified temperature range, the sensitivity can be optimized to be the highest. The performance of the junction temperature $T_J$ estimation circuit can be optimized to get the best precision in each range of temperatures.

Since a junction temperature $T_J$ has been estimated, the following operation can be implemented:

    f. modify the value of said resistance $R_{emu}$ of the emulator circuit EMU such that a corresponding temperature estimation range is modified and that the estimated value of a junction temperature $T_J$ get closer to the middle of the modified temperature estimation range;

    g1. if the estimated value of the junction temperature $T_J$ is sufficiently centered in the middle of the modified temperature estimation range according to predefined criteria, modify the value of said capacitor $C_{emu}$ of the emulator circuit EMU such that the sensitivity is increased (and the range is reduced);

    g2. if the estimated value of the junction temperature $T_J$ is not sufficiently centered in the middle of the modified temperature estimation range according to predefined criteria, modify the value of said capacitor $C_{emu}$ of the emulator circuit EMU such that the sensitivity is decreased (and the range is increased).

The above operations are graphically illustrated on [Fig. 12]. In a first scenario (left part of [Fig. 12]), the junction temperature $T_J$ is estimated as being $T_{J1}$. The value $T_{J1}$ is sufficiently centered in the measured range (curve "A"). Then, the time-to-temperature sensitivity is increased, and the value $T_{J1}$ is kept centered in the measured range (curve "B"). The time-to-temperature sensitivity is increased again, and the value $T_{J1}$ is again kept centered in the measured range (curve "C"). In a second scenario (right part of [Fig. 12]), the junction temperature $T_J$ changes (increases in the example) and is estimated as being $T_{J2}$. The junction temperature $T_J=T_{J2}$ is not in the measurement range anymore (curve "C"). The time-to-temperature sensitivity is decreased (by modifying the value of the capacitor $C_{emu}$ of the emulator circuit): the temperature $T_{J2}$ is in the measurement range but is not centered (Curve "D"). The temperature range is moved to center the estimated temperature $T_{J2}$ (by modifying the value of the resistance $R_{emu}$ of the emulator circuit ; Curve "E")), and the sensitivity is increased (by modifying the value of the capacitor $C_{emu}$ of the emulator circuit ; Curve "F").

In the example of [Fig. 12], the temperature range is maximized to know the approximate temperature range of the transistor. Once the range of the temperature is known, the controller applies the algorithm to set the value of $R_{emu}$ to focus on the temperature and $C_{emu}$ is adjusted to optimize the resolution. When the temperature of the transistor changes, the algorithm readjusts $R_{emu}$ and $C_{emu}$ to focus the measurement on the new temperature.

To summarize, by approaching $C_{emu}$ close to $C_g$, the time sensitivity can be increased. This allows to precisely measure a large range of temperature and over-passed the trade-off range/sensitivity by using different algorithms. Dynamic iterations are implemented to set the emulator circuit ($R_{emu}$ and $C_{emu}$). The range/sensitivity trade-off is over-passed. In other words, using several iterations, both a high measurement range and a high sensitivity can be reached.

Only as examples, [Fig. 13] and [Fig. 14] show examples of dynamic estimation/calibration algorithm implementations. The example of [Fig. 13] is general and the example of [Fig. 14] is more detailed to consider the two cases above described with respect to [Fig. 5], [Fig. 6] and [Fig. 11].

In various embodiments, dynamic estimation of the temperature by using tunable $R_{emu}$ and $C_{emu}$ parameters can also be done by fixing the time duration t close to "0" (to obtain $R_g(T)$ ; see [Math. 1]). This method is shown on [Fig. 15], where $C_{emu}$ is constant and $R_{emu}$ is tuned until obtaining different output voltages between the transistor and the emulator circuit ($V_{CMP}$ = 1). This allows to determinate the temperature and the gate resistance $R_g(T)$ value by using a regulator, for example a Proportional, Integral one ("PI" on [Fig. 15]). The value $R_g$ and the temperature $T_J$ can be estimated without measuring the time duration of the output signal of the comparator COMP.

## Industrial Applicability

An aim of the previous description is to measure a junction temperature of a power transistor using the internal gate resistance $R_g$ as TSEP at high resolution, low circuit cost, low calibration effort, and with a high circuit genericity. Optionally, calibrations can be made. Two equal currents are injected simultaneously through a control electrode of the transistor (generally the gate) and through an equivalent RC circuit called "emulator circuit". In the embodiments wherein we want to do more than a measure/estimation on a specific transistor, we can further implement calibration steps by using tunable emulator circuit (the resistance $R_{emu}$ and/or the capacitance $C_{emu}$ being tuned to be in the same range of respectively $R_g$ and $C_g$ of the transistor). The voltages $V_{ge}$ and $V_{emu}$ are compared with an analogue comparator. The time duration (not the amplitude by itself) of the output signal of the comparator is linearly proportional to the temperature of the transistor. This allows to measure the junction temperature of the transistor without ADC. In addition, by using tunable resistor and capacitor controlled by a controller, for example an FPGA, it is possible to make calibration *in situ* for different components properties and to repeat the calibration during the operational life of the module to compensate deviation.

Without limitation, modules according to the above can be used, for example, as power modules and inverters in automotive and powertrain technical fields, in factory automation, air-conditioning systems, HVDC and renewable energies.

## Reference Signs List

**[0058]**   - 1: module

- CPS: current pulse source
- CC: current copier
- TR: transistor
- EMU: emulator circuit
- COMP: comparator
- CHR: time detector
- CONT: Controller.

## Claims

**1.** A measurement method for estimating junction temperatures of a power semi-conductor module (1) comprising:

a. duplicating a pulse current in two duplicated pulse currents;
b. injecting simultaneously

- a first duplicated pulse current to a control electrode (G) of a power transistor (TR) of said power semi-conductor module (1), and
- a second duplicated pulse current to an emulator circuit (EMU) comprising a resistance ($R_{emu}$) in series with a capacitor ($C_{emu}$);

c. comparing a voltage signal ($V_{ge}$) across said control electrode (G) of said power transistor (TR) and a voltage signal ($V_{emu}$) across said emulator circuit (EMU) in such a way to generate a comparison signal ($V_{CMP}$);

**characterized by**:
d. in function of said comparison signal ($V_{CMP}$), measuring duration ($\Delta t$) of said voltage signal ($V_{ge}$) of said power transistor (TR) to reach the same value as said voltage signal ($V_{emu}$) of said emulator circuit (EMU);
e. converting said measured duration ($\Delta t$) into an estimated value of a junction temperature ($T_J$);
f. modify the value of said resistance ($R_{emu}$) across the emulator circuit (EMU) such that a corresponding temperature estimation range is modified and that the estimated value of a junction temperature ($T_J$) get closer to the middle of the modified temperature estimation range;

> g1. if the estimated value of the junction temperature ($T_J$) is sufficiently centered in the middle of the modified temperature estimation range according to predefined criteria, modify the value of said capacitor ($C_{emu}$) of the emulator circuit (EMU) such that the sensitivity is increased;
> g2. if the estimated value of the junction temperature ($T_J$) is not sufficiently centered in the middle of the modified temperature estimation range according to said predefined criteria, modify the value of said capacitor ($C_{emu}$) of the emulator circuit (EMU) such that the sensitivity is decreased.

2. Method according to the preceding claim, wherein said resistance ($R_{emu}$ of said emulator circuit (EMU) is tunable,

> wherein the value of said resistance ($R_{emu}$) is set in such a way that the temperature estimation range position is selected, and
> wherein said capacitor ($C_{emu}$) of said emulator circuit (EMU) is tunable and wherein the value of said capacitor ($C_{emu}$) is set in such a way that the temperature estimation range amplitude is selected.

3. Method according to one of claims 1 and 2, further comprising iteratively modifying the value of said resistance ($R_{emu}$) while the time duration t is fixed to a value close to zero and until the generated comparison signal ($V_{CMP}$) corresponds to a situation wherein said voltage signal ($V_{ge}$) across said control electrode (G) of said power transistor (TR) is equal to said voltage signal ($V_{emu}$) across said emulator circuit (EMU).

4. Computer software comprising instructions to cause a power semi-conductor module to implement the method according to one of claims 1 to 3 when the software is executed by a processor, wherein the power semi-conductor module comprises:

> - at least one power transistor (TR);
> - a current pulse source (CPS) that is provided through a control electrode (G) of said power transistor(TR);
> - a current copier (CC) arranged to duplicate the current provided by the current pulse source (CPS);
> - an emulator circuit (EMU) comprising a resistance ($R_{emu}$) in series with a capacitor ($C_{emu}$ );
> - a comparator (COMP) arranged to compare a voltage signal ($V_{ge}$) across said control electrode (G) of said power transistor (TR) and a voltage signal ($V_{emu}$) across said emulator circuit (EMU) in such a way to generate a comparison signal ($V_{CMP}$); and
> - a time detector (CHR) arranged to measure a time duration of said comparison signal ($V_{CMP}$).

5. Computer software according to claim 4, wherein the power semi-conductor module (1) further comprises:

> - a controller (CONT) arranged to tune said resistance ($R_{emu}$) and/or said capacitor ($C_{emu}$).

6. Computer-readable non-transient recording medium on which a software is registered to implement a method according to one of claims 1 to 3 when the software is executed by a processor.

**Patentansprüche**

1. Messverfahren zum Schätzen von Übergang-Temperaturen eines Halbleiter-Leistungsmoduls (1), umfassend:

> a. Duplizieren eines Pulsstroms in zwei duplizierte Pulsströme;
> b. gleichzeitiges Eingeben

> > - eines ersten duplizierten Pulsstroms zu einer Steuerelektrode (G) eines Leistungstransistors (TR) des Halbleiter-Leistungsmoduls (1), und
> > - eines zweiten duplizierten Pulsstroms zu einer Emulatorschaltung (EMU), welche einen Widerstand ($R_{emu}$)

in Reihe mit einem Kondensator ($C_{emu}$) umfasst;

c. Vergleichen eines Spannungssignals ($V_{ge}$) über die Steuerelektrode (G) des Leistungstransistors (TR) und eines Spannungssignals ($V_{emu}$) über die Emulatorschaltung (EMU) derart, dass ein Vergleichssignal ($V_{CMP}$) erzeugt wird;

**gekennzeichnet durch**:

d. als Funktion des Vergleichssignals ($V_{CMP}$), Messen einer Dauer ($\Delta t$) des Spannungssignals ($V_{ge}$) des Leistungstransistors (TR), bis es denselben Wert wie das Spannungssignal ($V_{emu}$) der Emulatorschaltung (EMU) erreicht;

e. Konvertieren der gemessenen Dauer ($\Delta t$) in einen geschätzten Wert einer Übergang-Temperatur ($T_j$);

f. Modifizieren des Werts des Widerstands ($R_{emu}$) über die Emulatorschaltung (EMU) derart, dass ein entsprechender Temperatur-Schätzbereich modifiziert wird, und dass der geschätzte Wert einer Übergang-Temperatur ($T_j$) näher zu der Mitte des modifizierten Temperatur-Schätzbereichs kommt;

g1. wenn der geschätzte Wert der Übergang-Temperatur ($T_j$) ausreichend in der Mitte des modifizierten Temperatur-Schätzbereichs gemäß vorbestimmter Kriterien zentriert ist, Modifizieren des Werts des Kondensators ($C_{emu}$) der Emulatorschaltung (EMU) derart, dass die Sensitivität erhöht wird;

g2. wenn der geschätzte Wert der Übergang-Temperatur ($T_j$) nicht ausreichend in der Mitte des modifizierten Temperatur-Schätzbereichs gemäß den vorbestimmten Kriterien zentriert ist, Modifizieren des Werts des Kondensators ($C_{emu}$) der Emulatorschaltung (EMU), so dass die Sensitivität verringert wird.

2. Verfahren nach dem vorhergehenden Anspruch, wobei der Widerstand ($R_{emu}$) der Emulatorschaltung (EMU) einstellbar ist,

wobei der Wert des Widerstands ($R_{emu}$) derart gesetzt wird, dass die Temperatur-Schätzbereichsposition ausgewählt wird, und

wobei der Kondensator ($C_{emu}$) der Emulatorschaltung (EMU) einstellbar ist und wobei der Wert des Kondensators ($C_{emu}$) derart gesetzt wird, dass die Temperatur-Schätzbereichsamplitude ausgewählt wird.

3. Verfahren nach einem der Ansprüche 1 und 2, ferner umfassend ein iteratives Modifizieren des Werts des Widerstands ($R_{emu}$), während die Zeitdauer t auf einen Wert nahe null festgelegt ist und bis das erzeugte Vergleichssignal ($V_{CMP}$) einer Situation entspricht, in welcher das Spannungssignal ($V_{ge}$) über die Steuerelektrode (G) des Leistungstransistors (TR) gleich dem Spannungssignal ($V_{emu}$) über die Emulatorschaltung (EMU) ist.

4. Computer-Software, umfassend Anweisungen zum Veranlassen eines Halbleiter-Leistungsmoduls, das Verfahren nach einem der Ansprüche 1 bis 3 zu implementieren, wenn die Software von einem Prozessor ausgeführt wird, wobei das Halbleiter-Leistungsmodul umfasst:

- wenigstens einen Leistungstransistor (TR);
- eine Strompuls-Quelle (CPS), welche durch eine Steuerelektrode (G) des Leistungstransistors (TR) bereitgestellt ist;
- eine Strom-Kopiereinheit (CC), welche dazu eingerichtet ist, den Strom zu duplizieren, welcher von der Strompuls-Quelle (CPS) bereitgestellt wird;
- eine Emulatorschaltung (EMU), welche einen Widerstand ($R_{emu}$) in Reihe mit einem Kondensator ($C_{emu}$) umfasst;
- einen Komparator (COMP), welcher dazu eingerichtet ist, ein Spannungssignal ($V_{ge}$) über die Steuerelektrode (G) des Leistungstransistors (TR) und ein Spannungssignal ($V_{emu}$) über die Emulatorschaltung (EMU) derart zu vergleichen, dass ein Vergleichssignal ($V_{CMP}$) erzeugt wird; und
- einen Zeitdetektor (CHR), welcher dazu eingerichtet ist, eine Zeitdauer des Vergleichssignals ($V_{CMP}$) zu messen.

5. Computer-Software nach Anspruch 4, wobei das Halbleiter-Leistungsmodul (1) ferner umfasst:

- eine Steuereinheit (CONT), welche dazu eingerichtet ist, den Widerstand ($R_{emu}$) und/oder den Kondensator ($C_{emu}$) einzustellen.

6. Computerlesbares nichtflüchtiges Aufzeichnungsmedium, auf welchem eine Software registriert ist, um ein Verfahren nach einem der Ansprüche 1 bis 3 zu implementieren, wenn die Software von einem Prozessor ausgeführt wird.

**Revendications**

1. Procédé de mesure pour estimer les températures de jonction d'un module semiconducteur de puissance (1) comprenant :

    a. la duplication d'un courant d'impulsion en deux courants d'impulsion dupliqués ;
    b. l'injection simultanée

        - d'un premier courant d'impulsion dupliqué dans une électrode de commande (G) d'un transistor de puissance (TR) dudit module semiconducteur de puissance (1), et
        - d'un second courant d'impulsion dupliqué dans un circuit émulateur (EMU) comprenant une résistance ($R_{emu}$) en série avec un condensateur ($C_{emu}$) ;

    c. la comparaison d'un signal de tension ($V_{ge}$) à travers ladite électrode de commande (G) dudit transistor de puissance (TR) et d'un signal de tension ($V_{emu}$) à travers ledit circuit émulateur (EMU) de manière à générer un signal de comparaison ($V_{CMP}$) ; **caractérisé par** :
    d. en fonction dudit signal de comparaison ($V_{CMP}$), la mesure de la durée ($\Delta t$) dudit signal de tension ($V_{ge}$) dudit transistor de puissance (TR) pour atteindre la même valeur que ledit signal de tension ($V_{emu}$) dudit circuit émulateur (EMU) ;
    e. la conversion de ladite durée mesurée ($\Delta t$) en une valeur estimée d'une température de jonction ($T_J$) ;
    f. la modification de la valeur de ladite résistance ($R_{emu}$) à travers le circuit émulateur (EMU) de sorte qu'une plage d'estimation de température correspondante soit modifiée et que la valeur estimée d'une température de jonction ($T_J$) se rapproche du milieu de la plage d'estimation de température modifiée ;

        g1. si la valeur estimée de la température de jonction ($T_J$) est suffisamment centrée au milieu de la plage d'estimation de température modifiée selon des critères prédéfinis, la modification de la valeur dudit condensateur ($C_{emu}$) du circuit émulateur (EMU) de manière à augmenter la sensibilité ;
        g2. si la valeur estimée de la température de jonction ($T_J$) n'est pas suffisamment centrée au milieu de la plage d'estimation de température modifiée selon lesdits critères prédéfinis, la modification de la valeur dudit condensateur ($C_{emu}$) du circuit émulateur (EMU) de manière à diminuer la sensibilité.

2. Procédé selon la revendication précédente, dans lequel ladite résistance ($R_{emu}$) dudit circuit émulateur (EMU) est réglable,

    dans lequel la valeur de ladite résistance ($R_{emu}$) est définie de manière à ce que la position de la plage d'estimation de température soit sélectionnée, et
    dans lequel ledit condensateur ($C_{emu}$) dudit circuit d'émulateur (EMU) est réglable et dans lequel la valeur dudit condensateur ($C_{emu}$) est définie de manière à ce que l'amplitude de la plage d'estimation de température soit sélectionnée.

3. Procédé selon l'une des revendications 1 et 2, comprenant en outre la modification itérative de la valeur de ladite résistance ($R_{emu}$) tandis que la durée t est fixée à une valeur proche de zéro et jusqu'à ce que le signal de comparaison ($V_{CMP}$) généré corresponde à une situation dans laquelle ledit signal de tension ($V_{ge}$) à travers ladite électrode de commande (G) dudit transistor de puissance (TR) est égal audit signal de tension ($V_{emu}$) à travers ledit circuit émulateur (EMU).

4. Logiciel informatique comprenant des instructions pour amener un module semiconducteur de puissance à mettre en œuvre le procédé selon l'une des revendications 1 à 3 lorsque le logiciel est exécuté par un processeur, dans lequel le module semiconducteur de puissance comprend :

    - au moins un transistor de puissance (TR) ;
    - une source d'impulsion de courant (CPS) qui est fournie par une électrode de commande (G) dudit transistor de puissance (TR) ;
    - un copieur de courant (CC) agencé pour dupliquer le courant fourni par la source d'impulsion de courant (CPS) ;

- un circuit émulateur (EMU) comprenant une résistance ($R_{emu}$) en série avec un condensateur ($C_{emu}$) ;
- un comparateur (COMP) agencé pour comparer un signal de tension ($V_{ge}$) à travers ladite électrode de commande (G) dudit transistor de puissance (TR) et un signal de tension ($V_{emu}$) à travers ledit circuit émulateur (EMU) de manière à générer un signal de comparaison ($V_{CMP}$) ; et
- un détecteur de temps (CHR) agencé pour mesurer une durée dudit signal de comparaison ($V_{CMP}$).

5. Logiciel informatique selon la revendication 4, dans lequel le module semiconducteur de puissance (1) comprend en outre :

- un dispositif de commande (CONT) agencé pour régler ladite résistance ($R_{emu}$) et/ou ledit condensateur ($C_{emu}$).

6. Support d'enregistrement non transitoire lisible par ordinateur sur lequel un logiciel est enregistré pour mettre en œuvre un procédé selon l'une des revendications 1 à 3 lorsque le logiciel est exécuté par un processeur.

FIG. 1

CHR

$V_{CMP}$

COMP

$V_{ge}$

$V_{emu}$

TR

$R_g$

$C_g$

g

e

e

g

G

EMU

$R_{emu}$

$C_{emu}$

CC

CPS

FIG. 2

FIG. 3

FIG. 4

$C_g > C_{emu}$ & $R_g(T) > R_{emu}$

**FIG. 5**

$C_g < C_{emu}$ & $R_g(T) < R_{emu}$

**FIG. 6**

**FIG. 7**

FIG. 8

Cal_Init () — n

$R_{emu}$ = Min ($R_{emu}$) ; $C_{emu}$ = Min ($C_{emu}$)
$t = t_1$

T1 — $\nearrow R_{emu}$
$V_{CMP} = 0$ ? — n

$t = t_2$

$\nearrow C_{emu}$
$V_{CMP} = 0$ ? — n

T2 — $\nearrow t$
$V_{CMP} = 0$ ? — n

Cal_Stop ()

FIG. 9

```
┌──────────────────────────────────────┐    n
│          Cal_Init ()                  │◄──┐
└──────────────────────────────────────┘   │
              │ y                            │
              ▼                              │
┌──────────────────────────────────────┐    │
│      C_emu = Min (C_emu)              │    │
└──────────────────────────────────────┘    │
              │                              │
              ▼                              │
┌──────────────────────────────────────┐   n │
T1 ──►│          ↗ t                    │◄──┐ │
│         V_CMP = 1 ?                   │   │ │
└──────────────────────────────────────┘   │ │
              │ y                            │
              ▼                              │
┌──────────────────────────────────────┐    │
│          t = t_2                      │    │
└──────────────────────────────────────┘    │
              │                              │
              ▼                              │
┌──────────────────────────────────────┐   n │
│          ↗ C_emu                      │◄──┐ │
│         V_CMP = 0 ?                   │   │ │
└──────────────────────────────────────┘   │ │
              │ y                            │
              ▼                              │
┌──────────────────────────────────────┐   n │
T2 ──►│          ↗ t                    │◄──┐ │
│         V_CMP = 0 ?                   │   │ │
└──────────────────────────────────────┘   │ │
              │ y                            │
              ▼                              │
┌──────────────────────────────────────┐    │
│          Cal_Stop ()                  │    │
└──────────────────────────────────────┘    │
```

**FIG. 10**

FIG. 11

EP 4 439 026 B1

FIG. 12

$T_J$ ?

$\Delta t$ ?

$V_{CMP} = 0$

$V_{CMP} = [0;1]$

$V_{CMP} = 1$

$[t_{min} ; t_{max}] \ll t(T_J)$

$[t_{min} ; t_{max}] \sim t(T_J)$

$[t_{min} ; t_{max}] \gg t(T_J)$

$\searrow R_{emu}$

$\searrow R_{emu}$

$\nearrow R_{emu}$

$\nearrow R_{emu}$

$\searrow C_{emu}$

$\nearrow C_{emu}$

$\searrow C_{emu}$

Cal_Stop ()

**FIG. 13**

**FIG. 14**

EP 4 439 026 B1

COMP

$R_g (T)$

$R_{emu}$

$t = cte \approx 0$
$C_{emu} = cte$

PI

$R_g$ and T

**FIG. 15**

## REFERENCES CITED IN THE DESCRIPTION

### Patent documents cited in the description

- EP 3855145 A1